# EUROPEAN PATENT APPLICATION

(11) **EP 4 810 981 A1**
(43) Date of publication of application: **23.09.2026**
(21) Application number: 25164956.2
(22) Date of filing: 20.03.2025
(51) Int. Cl.: G01R 33/56

(54) **MAGNETIC RESONANCE IMAGING USING CEST CONTRAST CORRECTION**

(71) Applicant: Koninklijke Philips N.V., 5656 AE Eindhoven (NL)
(72) Inventor: KEUPP, Jochen, Eindhoven (NL)
(74) Representative: Philips Intellectual Property & Standards

(57) **Abstract**

Methods and systems for imaging at least a part of a body are presented. The method comprises: acquiring signals by subjecting the portion of the body (10) to a chemical exchange saturation transfer (CEST) imaging protocol including radiofrequency saturation at a number of different saturation frequency offsets; generating a Z-spectrum from the acquired signals for each voxel of a set of voxels for a magnetic resonance image; deriving for each voxel a signal metric based on the Z-spectrum; applying a scaling function for the signal metric depending on the Z-value in each voxel to perform a basic correction comprising spillover correction; forming a Z-dependent rescaling function by defining a handover Z-value of the Z-dependent scaling function for ensuring transition of the Z-dependent scaling function to a rampdown function for Z-values larger than the handover value, and defining a cut-off Z-value for setting the rescaling function to zero-level for Z-values larger than the cut-off Z-value; correcting the signal metric based on the Z-dependent rescaling function; and deriving a CEST signal based on the corrected signal metric. The system comprises a computational system configured to perform the method.

## Description

### FIELD OF THE INVENTION

The invention relates to the field of magnetic resonance imaging. It concerns a method of magnetic resonance imaging, a magnetic resonance imaging system and a computer program for a magnetic resonance imaging system.

### BACKGROUND OF THE INVENTION

Image-forming magnetic resonance (MR) methods that utilize the interaction between magnetic fields and nuclear spins in order to form two-dimensional or three-dimensional images are widely used nowadays, notably in the field of medical diagnostics, due to their superiority for imaging soft tissue to other imaging methods, mainly because of not requiring ionizing radiation and being usually not invasive.

In some medical applications, the difference in MR signal intensity from standard magnetic resonance imaging (MRI) protocols, i.e. the contrast between different tissues, might not be sufficient to obtain satisfactory clinical information. In this case, contrast enhancing techniques are applied. A known approach for contrast enhancement and increasing of MR detection sensitivity (by orders of magnitude) is the known method based on Chemical Exchange Saturation Transfer (CEST), as initially described by Balaban et al. in US 2008/0167549 A1. With this CEST technique, the image contrast is obtained by altering the intensity of the water proton signal in the presence of a contrast agent or an endogenous molecule with a proton pool resonating at a different frequency than the main water resonance. This is achieved by selectively saturating the nuclear magnetization of the pool of exchangeable protons which resonate at a frequency different from the water proton resonance. Exchangeable protons can be provided by exogenous CEST contrast agents (e.g. DIACEST, PARACEST or LIPOCEST agents), but can also be found in biological tissue (i.e., endogenous amide protons in proteins and peptides, protons in glucose or protons in metabolites like choline or creatinine). A frequency-selective saturation RF pulse that is matched to the MR frequency of the exchangeable protons is used for this purpose. The saturation of the MR signal of the exchangeable protons is subsequently transferred to the MR signal of nearby water protons within the body of the examined patient by chemical exchange with the water protons, thereby decreasing the water proton MR signal. The selective saturation at the MR frequency of the exchangeable protons thus gives rise to a negative contrast in a proton-density weighted MR image.

Amide proton transfer weighted (APTw) MR imaging, which is a CEST technique based on endogenous exchangeable protons, allows highly sensitive and specific detection of pathological processes on a molecular level, like increased protein concentrations in malignant tumor tissue. The APT signal is also sensitively reporting on locally altered pH levels - because the exchange rate is pH dependent - which can e.g., be used to characterize ischemic stroke. APTw CEST MR imaging has several advantages over conventional MR contrasts with or without contrast agents. APTw CEST MR imaging allows highly specific detection and differentiation of exogenous and endogenous contrasts, which is much more sensitive than e.g., spectroscopic MR or NMR techniques. This high sensitivity (signal to noise ratio, SNR, efficiency) can be used to obtain molecular contrast information at a resolution comparable to typical MR imaging applications in clinically acceptable examination times.

Compared with MR signals acquired without RF saturation, the signal reductions at certain saturation frequency offsets derive not only from the CEST effect, but also from direct saturation of the water protons and, moreover, from magnetization transfer (MT) from semisolid macromolecules during in-vivo imaging. Direct saturation and also MT can be assumed to cause signal reductions that are symmetrical with respect to the resonance frequency of water protons. In conventional CEST MR imaging, therefore, the effect of the saturation transfer of exchangeable protons to water is conventionally identified for each image voxel by an asymmetry analysis (MTR_{asym}) of the amplitude of the acquired MR signals as a function of the saturation frequency offset, the so-called Z-spectrum. This asymmetry analysis is performed with respect to the MR frequency of water protons, which, for convenience, is assigned to a saturation frequency offset of 0 ppm.

An inherent shortcoming of MTR_{asym} analysis is that CEST effects from fluid compartments (low MT effect) are enhanced, such that fluid rich tissues often show a strong hyperintensity. Likewise, in areas with high MT effects, CEST effects tend to be underestimated by MTR_{asym} analysis. Both effects have been addressed by spillover correction, for example by using an inverse MTRᵣₑₓ metric according to Zaiss M, et al., Inverse Z-spectrum analysis for spillover-, MT-, and T1 -corrected steady-state pulsed CEST-MRI-application to pH-weighted MRI of acute stroke, NMR Biomed. 2014; 27(3): 240-52, herewith incorporated by reference in its entirety.

The measurement of the amplitude of the acquired MR signals as a function of the saturation frequency offset and the asymmetry analysis are inherently very sensitive to any inhomogeneity of the main magnetic field B₀. This is because a small shift of the center frequency (e.g., a saturation frequency offset of 0.1 ppm relative to the chemical shift of water) easily causes a variation of more than 10% in the asymmetry data. This variation results in large artifacts in the finally reconstructed CEST contrast images. It has been shown by Zhou et al., Magnetic Resonance in Medicine, 60, 842-849, 2008, that the B₀ inhomogeneity can be corrected in APTw imaging on a voxel-by-voxel basis through re-centering of the Z-spectrum on the basis of a separately acquired B₀ map.

### SUMMARY OF THE INVENTION

An object of the invention is to provide an improved MR imaging method and an MRI system enabling additional CEST signal correction for compartments with significant fluid content based on spillover corrected CEST metrics.

In accordance with the invention, a method of MR imaging of at least a portion of a body is provided, comprising:
acquiring signals by subjecting the portion of the body (10) to a chemical exchange saturation transfer (CEST) imaging protocol including radiofrequency (RF) saturation at a number of different saturation frequency offsets;
generating a Z-spectrum from the acquired signals for each voxel of a set of voxels for a magnetic resonance image;
deriving for each voxel a signal metric based on the Z-spectrum;
applying a scaling function for the signal metric depending on the Z-value in each voxel to perform a basic correction comprising spillover correction;
forming a Z-dependent rescaling function by:
   defining a handover Z-value of the Z-dependent scaling function for ensuring transition of the Z-dependent scaling function to a rampdown function for Z-values larger than the handover value; and
   defining a cut-off Z-value for setting the rescaling function to zero-level for Z-values larger than the cut-off Z-value;
correcting the signal metric based on the Z-dependent rescaling function; and
deriving a CEST signal based on the corrected signal metric.

In an embodiment forming a Z-dependent rescaling function further comprises defining a maximum threshold limit of the Z-dependent rescaling function for preventing noise amplification in signal originating from tissue with high magnetization transfer and/or low magnetization transfer asymmetry.

In an embodiment the signal metric comprises magnetization transfer asymmetry.

In an embodiment the Z-dependent scaling function selected for the basic correction for spillover is a 1/Z² correction, like MTRᵣₑₓ.

In any of the embodiments according to the invention the scaling function for the signal metric may depend on the average Z-value. The average Z-value is defined as Z=√(Z_{ref}×Z_{lab}) or Z=(Z_{ref}Z_{lab})/2. The nominal saturation frequency offset Δω for the CEST application defines the reference Z-value Z_{ref}=S[-Δω]/S0 and the label value Z_{lab}= S[+Δω]/S0.

In any of the embodiments the method may further comprise obtaining a B₀ map and applying a saturation frequency offset correction to the generated Z-spectra according to the B₀ map, wherein optionally, the B₀ map is obtained from the acquired signals by means of a single-point or multi-point Dixon technique.

In some embodiments the method may further comprise obtaining a B₁ map and applying a saturation frequency offset correction to the generated Z-spectra according to the B₁ map.

In some embodiments the method may further comprise obtaining a T1 map and applying a T1 correction for the generated Z-spectra or the CEST metrics according to the T1 map, e.g., apparent exchange-dependent relaxation (AREX).

In any of the embodiments the CEST imaging protocol may comprise any of a two-dimensional fast spin echo imaging, three-dimensional fast spin echo, gradient echo imaging and echo planar imaging, which can be used for example in two-dimensional (2D), 2D multi-slice and three-dimensional (3D) protocols.

In some embodiments the Z-dependent rescaling function comprises smooth transitions, for example the function being continuous or continuously differentiable, at the handover Z-value, at the cut-off Z-value and/or at the Z-value associated with the maximum threshold limit of the Z-dependent rescaling function.

In any of the embodiments the CEST signal may be an APTw signal and the fluid-suppressed CEST contrast signal is fluid-suppressed APTw contrast signal. While one important aim of APTw MRI is to characterize malignant lesions, particularly in oncology, other tissue types may show hyperintensity in APTw images and may be confounded with malignant lesions. In particular, tissue compartments with a significant fluid content and often high protein content show hyperintensity in APTw images, for example, but not exclusively: cysts, hemorrhage, CSF, edema, fluid parts of necrotic tissue etc. While these compartments may typically be ruled out by using multi-parametric MRI assessment, e.g., based on joint view of T1w, T2w or FLAIR MRI contrast, it is desirable to automatically suppress the APTw CEST signal in those compartments in order to simplify and improve diagnostic reading.

The application of spillover correction results in reduced contributions of fluid compartments but does not suppress the signal from those below the level related to actual protein concentrations. Also, spillover correction typically leads to an enhanced noise level in tissue compartments with high MT effect like normal appearing grey and white matter (NAGWM) in the brain. With standard CEST and APTw imaging protocols, MTR_{asym} in NAGWM is close to zero which leads to a significant noise enhancement by spillover correction related upscaling. Thus, clinical diagnosis of tissue malignancy with state-of-the-art fluid suppression techniques may still be confounded. Advanced fluid suppression techniques, for example in US11307277B2, have addressed the issue of insufficient fluid suppression for, but could not provide a precise spillover correction at the same time, leading to underestimation of CEST effects in tissue compartments with high MT levels. The invention provides significant improvement by combining precise correction of spillover and MT related CEST signal imperfections with extra fluid suppression to reduce confounders in clinical diagnosis.

The method according to the invention only requires a straightforward scaling operation as post-processing step. The scaling parameter can be adjusted for a specific application to suppress APTw hyperintensity caused by protein-rich fluids. No extra measurement time and no significant post-processing time is required.

The method of the invention described thus far can be carried out by means of an MRI system including at least one main magnet coil for generating a uniform steady magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstruction of an MR image from the received MR signals. The method of the invention is preferably implemented by a corresponding programming of the control unit and/or the reconstruction unit of the MRI system. In some embodiments the method further comprises outputting the CEST signals to a display screen, which may be included in the MRI system or any peripheral display such as tablet screen, smartphone.

Any of the embodiments of the method according to the invention can be advantageously carried out by a system in most MR environments in clinical use at present. To this end it is merely necessary to utilize a computer program by which a computational system (e.g., a PC) is instructed to control a magnetic resonance imaging system and to perform any of the method embodiments of the invention. The computer program may be present either on a data carrier or be present in a data network so as to be downloaded for installation, e.g., into the control unit or the reconstruction unit of an MR system.

### BRIEF DESCRIPTION OF THE DRAWINGS

The enclosed drawings disclose preferred embodiments of the present invention. It should be understood, however, that the drawings are for the purpose of illustration only and not as a definition of the limits of the invention. In the drawings:
Fig. 1 shows an MR system according to the invention;
Fig. 2 shows a flow chart illustrating a method according to the invention;
Fig. 3 shows an example of a Z-dependent rescaling function according to the invention;
Fig. 4. shows example images according to the invention.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

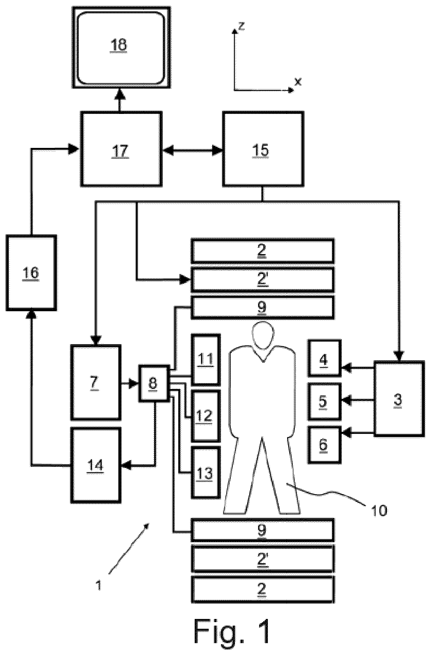

With reference to Fig. 1, an MRI system 1 is shown. The device comprises superconducting or resistive main magnet coils 2 such that a substantially uniform, temporally constant main magnetic field B₀ is created along a longitudinal z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along *x, y* and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments which, together with any applied magnetic field gradients, achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9. The MR imaging sequences or protocols may be stored in a memory. The memory is intended to represent any combination of memory or storage device which is accessible to a computational system configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and are demodulated by a receiver 14, preferably including a preamplifier (not shown). The receiver 14 is connected to the RF coils 9, 11, 12 and 13 via send-/receive switch 8.

The RF body coil or other segmented coils, such as the local array RF coils may comprise multiple RF transmission channels. They may use a special configuration with different transmission channel settings for RF saturation and imaging RF pulses.

A computer system or with other words a host computer 15 controls the shimming coils 2' as well as the gradient pulse amplifier 3 and the transmitter 7 to generate any of a plurality of MR imaging protocols, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. The digital raw image data may be stored in the memory. In modern MR devices the data acquisition system 16 is a separate computer which is specialized in the acquisition of raw image data.

The digital raw image data is used for generating or reconstructing an image representation by a reconstruction processor 17 which applies a Fourier transform or other appropriate reconstruction algorithms, such as SENSE, GRAPPA or Compressed Sensing. Generating the MR image can be based on algorithms stored in cloud-based memory, to which the raw image data is transmitted and the cloud-based computing system may perform the image reconstruction. The MR image is then transmitted back to the MRI system. The MR image may represent a planar slice through the patient, an array of parallel planar slices, a three-dimensional volume, or the like. The MR image may then be stored in a memory where it may be accessed for converting slices, projections, or other portions of the image representation into appropriate format for visualization on a display screen for presenting the information in user-readable manner. In some embodiments the functionalities of the host computer, the data acquisition system and the reconstruction are implemented in one computer system.

Without limitation by any of the features disclosed with reference to Fig. 1, the MRI system may comprise any further elements that allow use of any of the methods disclosed in US 2013/0342207 A1, which is incorporated herein by reference in its entirety.

As CEST MRI, and in particular APTw MRI, is used for MR-based molecular imaging of endogenous cytosolic proteins or peptides for clinical applications including oncology, and for assessment of tissue pH levels via the exchange rate for clinical applications including stroke management, it is of importance to improve sensitivity and specificity of the technique.

The measurement of amide protons is often based on a magnetization transfer asymmetry (MTR_{asym}) analysis on the water signal S[ω] using symmetric radiofrequency (RF) saturation frequency offsets ±Δω around the water resonance, while the APTw signal is found as image signal reduction around Δω=+3.5ppm. Other CEST pools may be found at different offsets and the metric is applied for the respective Δω values (e.g., hydroxyl(OH)-CEST at Δω=+1.2ppm). ${MTR}_{asym} = {Z}_{ref} - {Z}_{lab}$ ${Z}_{ref} = S \left[-Δω\right] / {S}_{0}$ ${Z}_{lab} = S \left[+Δω\right] / {S}_{0}$ ${S}_{0} = S \left[ω≪-Δω\right]$ (large saturation frequency offset) or S₀ =S[no RF saturation].

The subscripts "lab" and "ref" in Z_{lab} and Z_{ref} refer to labeling scan and reference scan, as also used in Zaiss M, et al., NMR Biomed. 2014; 27(3): 240-52.

The overall strength of the MT effect in a voxel is inversely measured by the average Z-value, Z ∈ [0,1], with high Z⇒1.0 for pure fluids (no MT effect). $Z \approx {Z}_{ref} \approx {Z}_{lab}$ and may be calculated by averaging Z_{ref} and Z_{lab}, e.g., $Z = \left({Z}_{ref}+{Z}_{lab}\right) / 2 or Z = √ \left({Z}_{ref}\times {Z}_{lab}\right) .$

The MTR_{asym} metric frequently suffers from the spillover dilution effect, which leads to overestimation of APTw or CEST signals in tissues with large water content as well to underestimation of signals from tissues with high MT effects. Alternative metrics like MTRᵣₑₓ, which is related to the exchange-dependent relaxation rate in the rotating frame and the inherent exchange rate, have been proposed to correct for spillover or MT, e.g., ${MTR}_{rex} = 1 / {Z}_{lab} - 1 / {Z}_{ref} ≅ {MTR}_{asym} \times {{Z}_{0}}^{2} / {Z}^{2}$

Fluid suppression has been introduced to solve the clinical issue, that malignant solid tissue, which shows elevated APTw signals such as tumors in oncology, may be confounded with other APTw hyperintensities. Tissue compartments with a significant fluid content often contain high protein concentrations, e.g., fluids in large heterogeneous tumors, and show hyperintensity in APTw images, for example, but not exclusively: cysts, hemorrhage, cerebrospinal fluid (CSF), edema, fluid parts of necrotic tissue, etc. While these compartments may typically be ruled out by using multi-parametric MRI assessment, e.g., based on joint view of T1w, T2w or FLAIR MRI contrasts, it is desirable to automatically suppress the APTw signal in those compartments to simplify and improve diagnostic reading. Known methods in the art to suppress fluid signal components including MT based metrics and spillover correction have their associated shortcomings. Previously described MT-based rescaling of MTR_{asym} for fluid suppression using linear (MTR_{FS1}∼ MTR_{asym}×(1-Z)) or exponential scaling functions (MTR_{FS2}∼ MTR_{asym}×(1-Z)^{ε}, ε>1.0) provide sufficient suppression of fluid compartments for practical use in clinical oncology applications but do not precisely correct for the spillover effect, such that APTw or CEST signals may be underestimated at moderate MT effect levels as compared to MTRᵣₑₓ.

On the other hand, spillover correcting metrics like MTRᵣₑₓ have shortcomings for practical use, which relates to insufficient suppression of fluid rich compartments and noise amplification for areas with low APTw or CEST signals with strong MT effects, like in normal appearing grey and white matter (NAGWM) of the human brain. The application of spillover correction results in reduced contributions of fluid compartments but does not suppress the signals from those beyond the actual level related to protein concentrations. Thus, the clinical diagnosis of malignancy may still be confounded.

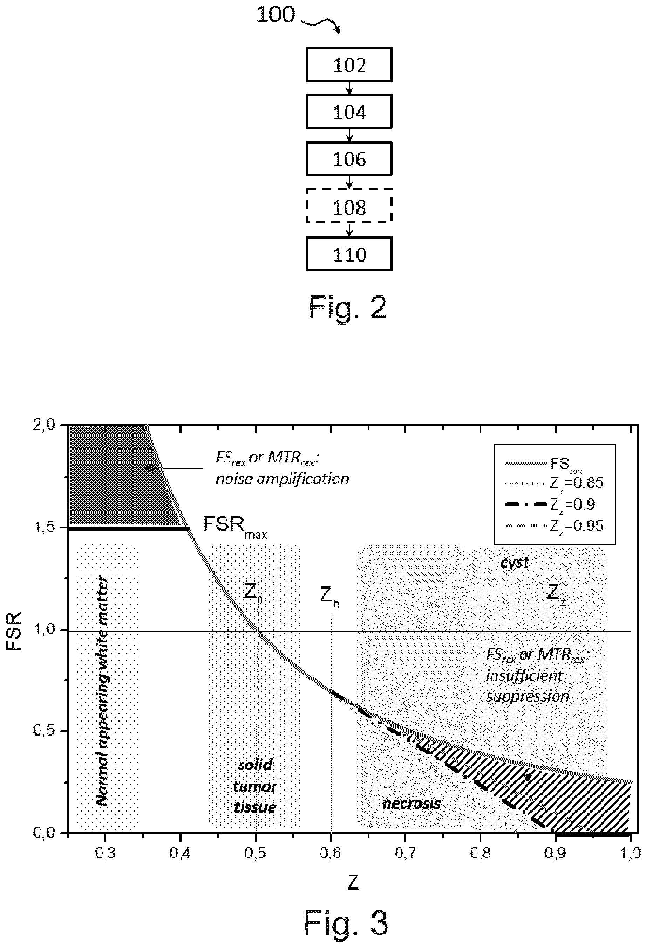

With reference to the flow chart illustrated in Fig. 2, a method 100 of deriving a fluid-suppressed APTw or CEST signal according to an embodiment of the invention is explained. The method addresses the need for clinically sufficient fluid suppression to suppress confounding CEST signal contributions and prevents noise enhancement while providing spillover-corrected magnetization transfer asymmetry values clinically relevant solid tissue types. The rescaling only requires straightforward operations as post-processing steps, hence no extra measurement time and no significant post-processing time is required.

The method relates to all kinds of Z-spectral processing methods for APTw or CEST-MRI that derive the APTw or CEST signal from spillover-corrected metrics, like for example MTRᵣₑₓ.

In step 102, a Z-spectrum with any of APTw or CEST signal acquisition techniques is acquired, which may include B₀ field correction and may include B₁ field correction. For example, two-dimensional (2D) or three-dimensional (3D) fast spin echo, gradient echo or echo planar imaging can be used for acquiring the Z-spectrum.

In step 104, a signal metric like MTR_{asym} is used to derive APTw or CEST signal. A magnetization transfer or spillover correcting metric like MTRᵣₑₓ = FSᵣₑₓ*MTR_{asym} or the apparent exchange-dependent relaxation (AREX) conform metric in Zaiss M, et al., NMR Biomed. 2014; 27(3): 240-52, is used as basic correction for MTR_{asym}, e.g., ${FS}_{rex} = {{Z}_{0}}^{2} / {Z}^{2}$ with an appropriate overall scaling factor Z₀. Z₀ depends on the clinical application and APTw or CEST acquisition protocol parameters, like RF saturation time Tₛₐₜ and saturation level B₁ᵣₘₛ. For example, Z₀=0.5 (Tₛₐₜ =2 s, B1ᵣₘₛ =2 µT) is preferably chosen for brain tumor applications.

In step 106, a handover value Zₕ is defined for the low MT effects (large Z, large fluid content), where the ramp down is effective (Z>Zₕ). Zₕ is in the interval of [0,1], preferably Zₕ>=0.6 for brain tumor applications. In general, Zₕ should be larger than the Z-value range for the solid tissue types of clinical interest for given clinical application, imaging protocol and RF saturation parameters.

A unitless Z-dependent rescaling factor FSR₁(Z) is calculated, with the following properties: $\begin{matrix}{FSR}_{1} \left(Z\right) = {FS}_{rex} \left(Z\right) & for Z < {Z}_{h} \\ {FSR}_{1} \left(Z\right) = {FS}_{rampdown} \left(Z\right) & for Z > = {Z}_{h}\end{matrix}$ wherein FSR stands for fluid suppression rescaled.

A seamless or smooth transition may be ensured by choosing FS_{rampdown} with the following criteria:
a) ${FS}_{rex} \left({Z}_{h}\right) = {FS}_{rampdown} \left({Z}_{h}\right)$
b) ${\partial }_{Z} {FS}_{rex} \left({Z}_{h}\right) = {\partial }_{Z} {FS}_{rampdown} \left({Z}_{h}\right)$

A zero-level cut-off is defined by a value Z_{z} for the ramp down function FS_{rampdown}. This means, for Z>=Z_{z}, the resulting FSR and CEST metric is scaled down to zero.

With FSᵣₑₓ = Z₀²/Z², a practical example for the seamless ramp down function is $\begin{matrix}{FS}_{rampdown} \left(Z\right) = \left(-2{{Z}_{0}}^{2}/{{Z}_{h}}^{3}\right) \times Z + 3 {{Z}_{0}}^{2} / {{Z}_{h}}^{2} for Z < {Z}_{z} \\ = 0.0 for Z > = {Z}_{z}\end{matrix}$

In this example, Zₕ = 2/3 * Z_{z}, as illustrated in Fig. 3.

Rescaling by a signal ramp down on top of the basic spillover-corrected APTw or CEST metric is used for tissue with low MT effect, such as having high fluid contents, with a seamless transition to the metric values at medium to high MT effects. In this way the APTw or CEST signals are fully suppressed if they originate from fluid compartments, thus beyond the level of suppression by spillover correction.

In step 108, which is an optional addition to the method 100, a limit FSRₘₐₓ is defined for upscaling by the rescaling function FSR₁(Z) in order to avoid noise amplification in tissues with high MT (Z⇒0) and/or low MTR_{asym}. For example: $\begin{matrix}FSR \left(Z\right) = {FSR}_{1} \left(Z\right) if {FSR}_{1} \left(Z\right) < {FSR}_{max} \\ = {FSR}_{max} if {FSR}_{1} \left(Z\right) > = {FSR}_{max}\end{matrix}$

A practical example for brain tumor applications is FSRₘₐₓ = 1.5, e.g., for brain tumor protocols with Tₛₐₜ =2 s, B1ᵣₘₛ =2 µT.

In step 110, the rescaled APTw or CEST signals are computed, by using: ${MTR}_{asym ; FSR} = FSR \left(Z\right) \times {MTR}_{asym}$

The fluid-suppressed APTw or CEST signals are output either to a peripheral, such as for example a screen display, or to further processing for preparation of a user-intelligible information, for example in a standardized color scale suitable for specific clinical applications. The information that is output may comprise an image generated based on the magnetic resonance imaging of an anatomy, wherein fluid-suppressed APTw or CEST results are comprised for at least a portion of the anatomy. Defining a portion of the anatomy may be performed based on segmentation of one or more anatomical regions within the magnetic resonance imaging data in response to inputting the magnetic resonance imaging data into an image segmentation algorithm comprised in the memory.

The fluid-suppressed APTw or CEST results may be used in addition to any contrast obtainable from the magnetic resonance imaging data, e.g., T1w, T2w, DWI, etc., or may be superimposed onto the contrast images. Fluid-suppressed APTw or CEST may replace specific contrasts like, e.g., contrast-enhanced T1w MRI, and consequently, the use of exogeneous contrast agents may be reduced.

Any of the method steps may be computer-implemented such that the computer system may carry out any or all of the method steps according to any of the embodiments of the method 100 disclosed hereinbefore. The memory may comprise computer executable instructions corresponding to algorithms associated to any or all of the method steps, such that execution of the instructions causes the computer system to perform any of the method embodiments according to the invention.

Fig. 3 illustrates the Z-dependent rescaling function FSR(Z) for APTw or CEST MRI, disclosed with reference to Fig. 2. While the metric follows MTRᵣₑₓ or FSᵣₑₓ (spillover correction) around the reference level Z₀, the extra fluid suppression is applied for Z-values larger than the handover value Zₕ by a ramp down function (e.g., a linear rampdown in the illustrated example), reaching a full suppression level at Z_{z}. The upscaling related to spillover or MT correction is limited to a level of FSRₘₐₓ for small Z values to avoid noise amplification (e.g., in normal appearing grey or white matter with high MT effect but very low MTR_{asym} for typical brain protocols, the difference between Z_{ref} and Z_{lab} being typically close or even below the noise level).

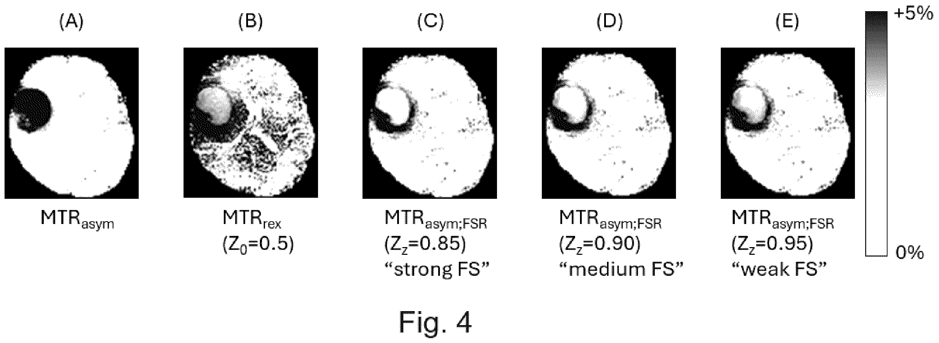

The method according to the invention is presented for illustration purpose with an example. Fig. 4 shows example images for rescaled fluid suppression (FSR) based on spillover correcting metrics from a glioblastoma patient case. In Fig. 4(A) MTR_{asym} is shown according to conventional computation. In Fig. 4(B) the MTRᵣₑₓ computation is performed based on Schüre JR, et. al., Fluid suppression in amide proton transfer-weighted (APTw) CEST imaging: New theoretical insights and clinical benefits, Magn Reson Med. 2024; 91(4):1354-1367, with consideration of Z₀=0.5, which shows limited fluid suppression in the tumor core and noise enhancement in normal appearing white and grey matter (NAWGM). In Fig. 4(C) the rescaled metric FSR according to the invention with strong fluid suppression (Z₀=0.5, Z_{z}=0.85, Zₕ=0.57, FSRₘₐₓ=1.5) shows sufficient extra fluid suppression in the fluid tumor core, maintains the contrast of solid tumor and shows only small noise enhancement in NAWGM. In Fig. 4(D) the rescaled metric FSR according to the invention with medium fluid suppression (Z_{z}=0.9, Zₕ=0.6) shows more signal from the tumor core. In Fig. 4(E) the rescaled metric FSR according to the invention is shown with weak fluid suppression (Z_{z}=0.95, Zₕ=0.63), with further increased signal from the tumor core. As apparent from the image examples, the strength of the fluid suppression can be modified by the choice of Z_{z} and Zₕ. Small Z_{z} and Zₕ values (e.g. Zₕ≈ 0.5 in brain) for very strong fluid suppression may lead to modifications of the spillover correction for relevant solid tissues. Thus, in a practical implementation, the largest possible Z_{z} and Zₕ values should be chosen, which still provide fully sufficient fluid suppression according to the clinical need to avoid confounders for a given clinical application and imaging protocol. In the example in Fig.4, only (C) showed full fluid suppression, so Z_{z}=0.85 and Zₕ=0.57 would be preferred.

The magnetic resonance imaging data was acquired on a 3.0T MRI-scanner (Ingenia Elition 3.0T, Philips, Netherlands) by using two-channels body-coil transmission and eight-channels head coil reception, with the following parameters: 40×50 ms = 2 s sinc-gaussian pulsed saturation (100% duty cycle by alternated transmission), B_{1,rms}=2 µT, 25 Z-spectral images S[ω] (ω=-6...6 ppm, step 0.5 ppm, and S₀, ω=-1560 ppm), 2D single-shot fast spin-echo, driven equilibrium refocusing, sensitivity encoding R=2, FOV=230×230 mm, voxel size=1.8×1.8×5 mm , TR/TE= 5 s/6.2 ms, acquisition time 2½ min. Separate GRE B₀ mapping was used for B₀ correction. All image data were analyzed using the software program ImageJ (version 1.47; U.S. National Institutes of Health, Bethesda, MD) and a dedicated processing plug-in.

The method according to the invention was performed by using the parameters:
Z₀=0.5, Z_{z}=0.85 or 0.9 or 0.95, FSRₘₐₓ=1.5. using a linear ramp down according to Eq. 4.

For Fig. 4(C) strong extra fluid suppression Z_{z}=0.85; Zₕ = 2/3 * Z_{z} = 0.57 ${FS}_{rampdown} \left(Z\right) = - 2.75 \times Z + 2.34 for Z < {Z}_{z} ; = 0.0 for Z \geq {Z}_{z}$

For Fig. 4(D) medium extra fluid suppression Z_{z}=0.9; Zₕ = 0.60 ${FS}_{rampdown} \left(Z\right) = - 2.31 \times Z + 2.08 for Z < {Z}_{z} ; = 0.0 for Z \geq {Z}_{z}$

For Fig. 4 (E) weak extra fluid suppression Z_{z}=0.95; Zₕ = 0.63 ${FS}_{rampdown} \left(Z\right) = - 1.97 \times Z + 1.87 for Z < {Z}_{z} ; = 0.0 for Z \geq {Z}_{z}$

In any of the embodiments the desired off-resonance frequency for CEST imaging may relate to any of the following entities (exchangeable pools): Amide (-NH), Hydroxyl (-OH), Amine (-NH₂), Imino-groups (=NH, double bound), exchange-relayed NOE, intra-liposomal water and bound water of molecules (complexes). These entities are involved in chemical exchange via proton exchange, molecular exchange, or compartmental exchange.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

## Claims

1. A method of imaging at least a part of a body (10), comprising:
acquiring signals by subjecting the portion of the body (10) to a chemical exchange saturation transfer, CEST, imaging protocol including radiofrequency saturation at a number of different saturation frequency offsets;
generating a Z-spectrum and a Z-value from the acquired signals for each voxel of a set of voxels for a magnetic resonance image;
deriving for each voxel a signal metric based on the Z-spectrum;
applying a scaling function for the signal metric depending on the Z-value in each voxel to perform a basic correction comprising spillover correction;
forming a Z-dependent rescaling function by:
defining a handover Z-value of the Z-dependent scaling function for ensuring transition of the Z-dependent scaling function to a rampdown function for Z-values larger than the handover value; and
defining a cut-off Z-value for setting the rescaling function to zero-level for Z-values larger than the cut-off Z-value;
correcting the signal metric based on the Z-dependent rescaling function;
deriving a CEST signal based on the corrected signal metric.

2. The method according to claim 1, wherein forming a Z-dependent rescaling function further comprises:
defining a maximum threshold limit of the Z-dependent rescaling function for preventing noise amplification in signal originating from tissue with high magnetization transfer and/or low magnetization transfer asymmetry.

3. The method according to any of the preceding claims, wherein the signal metric comprises magnetization transfer asymmetry.

4. The method according to any of the preceding claims, wherein the Z-dependent scaling function selected for the basic spillover correction is proportional to 1/Z², as for an MTRᵣₑₓ metric.

5. The method of any of the preceding claims, further comprising:
obtaining a B₀ map; and
applying for each voxel a saturation frequency offset correction to the generated Z-spectra according to the B₀ map, wherein optionally, the B₀ map is obtained from the acquired signals by means of a single-point or multi-point Dixon technique.

6. The method of any of the preceding claims, further comprising:
obtaining a B₁ map; and
applying for each voxel a B₁ correction to the generated Z-spectra or the CEST metric according to the B₁ map.

7. The method of any of the preceding claims, further comprising:
obtaining a T1 map; and
applying for each voxel a T1 correction for the generated Z-spectra or the CEST metric according to the T1 map.

8. The method of any of the preceding claims, wherein the CEST imaging protocol comprises any of a two-dimensional fast spin echo imaging, three-dimensional fast spin echo, gradient echo imaging and echo planar imaging.

9. The method of any of the preceding claims, wherein the CEST signal is an amide proton transfer weighted signal.

10. The method of any of the claims 1 to 8, wherein the off-resonance frequency for the CEST imaging protocol relates to any of the following exchangeable pools: amide, hydroxyl, amine, imino-groups, intra-liposomal water.

11. The method of any of the preceding claims, wherein the Z-dependent rescaling function comprises smooth transitions at the handover Z-value, at the cut-off Z-value and/or at the Z-value associated with the maximum threshold limit of the Z-dependent rescaling function.

12. The method according to any of the preceding claims, wherein the method further comprises outputting the CEST signals to a display screen.

13. A system for imaging at least a part of a body, comprising a computational system configured to perform a method according to any of the claims 1 to 12.

14. The system of claim 13, further comprising:
a magnetic resonance imaging system for acquiring signals by subjecting the portion of the body to the CEST imaging protocol;
a display screen configured to display the CEST signals.

15. A computer program comprising machine executable instructions, wherein execution of the machine executable instructions causes a computational system to perform a method according to any of the claims 1 to 12.
